# EUROPÄISCHE PATENTANMELDUNG

(11) **EP 0 911 937 A2**
(43) Veröffentlichungstag der Anmeldung: **28.04.1999**
(21) Anmeldenummer: 98117225.7
(22) Anmeldetag: 11.09.1998
(51) Int. Cl.: H02H 3/33, G01R 31/327

(54) **Einrichtung zum Prüfen eines Fehlerstromschutzschalters**

(30) Priorität: 21.10.1997 DE 19746315
(71) Anmelder: ABB PATENT GmbH, 68309 Mannheim (DE)
(72) Erfinder: Kahl, Walter Dipl.-Ing., 69190 Walldorf (DE)
(74) Vertreter: Miller, Toivo

(57) **Zusammenfassung**

Es wird eine Einrichtung zum Prüfen eines Fehlerstromschutzschalters beschrieben, der einen Summenstromwandler (10), dessen Primärwicklung durch die Netzleiter (L, N) gebildet und dessen Sekundärwicklung (11) mit einem Auslöserelais (12) verbunden sind. Der Fehlerstromschutzschalter besitzt weiterhin ein Schaltschloß (15), das vom Auslöserelais (12) bei Auftreten eines Fehlerstromes entklinkt wird, so daß in den Netzleitern (L, N) befindliche Kontaktstellen (17, 18) bleibend geöffnet werden. Dem Fehlerstromschutzschalter ist weiterhin ein Prüfstromkreis (19) zugeordnet, der zwischen einem Phasenleiter (L) und den Neutralleiter (N) einen Fehlerstrom simmuliert, wenn der Prüfkontakt (20) geschlossen wird, und der einen Prüfwiderstand (22) aufweist. Dem Prüfstromkreis (19) ist ein Zeitglied (23) zugeorndet, mit dem eine vorbestimmte Zeitdauer nach Schließen des Prüfkontaktes (20) ein Aktor (26, 39) ansteuerbar ist, der das bleibende, ggf. irreversible Ausschalten des Fehlerstromschutzschalters bewirkt.

## Beschreibung

Die Erfindung betrifft eine Einrichtung zum Prüfen eines Fehlerstromschutzschalters nach dem Oberbegriff des Anspruches 1.

Jeder Fehlerstromschutzschalter besitzt einen Summenstromwandler, dessen Primärwicklung durch die Netzleiter gebildet und dessen Sekundärwicklung mit einem Auslöserelais verbunden sind, es besitzt weiterhin ein Schaltschloß, das vom Auslöserelais beim Auftreten eines Fehlerstromes entklinkt wird, so daß Kontaktstellen in den Netzleitern bleibend geöffnet werden. Fehlerstromschutzschalter besitzen weiterhin einen Prüfstromkreis, mit dem zwischen einem Phasenleiter und dem Neutralleiter ein Fehlerstrom simuliert wird und der einen Prüfkontakt und einen Prüfwiderstand enthält. Wenn der Fehlerstromschutzschalter intakt ist, dann wird mit dem Schließen des Prüfkontaktes das Auslöserelais zum Ansprechen gebracht, so daß das Schaltschloß die Kontakte in den Netzleitern bleibend öffnet. Sollte es zu keiner Auslösung kommen, ist der Schalter defekt. Unter Umständen kann es hier zu Fehlinterpretationen kommen, so daß das Nichtauslösen vom Anwender als 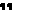 Fehlerstromschutzschalter in Ordnung" gewertet wird.

Aufgabe der Erfindung ist es, eine Einrichtung der eingangs genannten Art zu schaffen, bei der der Fehlerstromschutzschalter ggf. irreversibel auch dann ausgeschaltet wird, wenn der Fehlerstromschutzschalter defekt ist.

Diese Aufgabe wird erfindungsgemäß gelöst durch die kennzeichnenden Merkmale des Anspruches 1.

Demgemäß kann der Prüfstromkreis ein Zeitglied enthalten, mit dem eine vorbestimmte Zeitdauer nach Schließen des Prüfkontaktes ein Aktor ansteuerbar ist, der das bleibende, ggf. irreversible Ausschalten des Fehlerstromschutzschalters bewirkt.

Der Aktor kann dabei das Auslöserelais betätigen, wobei gemäß einer weiteren Ausführungsform der Aktor die Feder des Auslöserelais ist, die vom Prüfwiderstand erwärmt wird und ihre Federkonstante verändert, so daß durch die Feder das Auslöserelais geöffnet, d. h. der Klappanker vom Joch abgezogen wird. Dabei kann die Feder aus einer Formgedächtnislegierung (FGL) bestehen.

Es besteht auch die Möglichkeit, daß dem Klappanker ein Stößel zugeordnet ist, der eine weitere Feder aus einer Formgedächtnislegierung trägt, die den Stößel gegen den Klappanker bewegt und diesen aufschlägt, sobald sie aufgrund erhöhter Temperatur ihre Form ändert.

Es besteht weiterhin die Möglichkeit, daß der Aktor das Schaltschloß des Fehlerstromschutzschalters entklinkt. Dies kann in bevorzugter Weise dadurch geschehen, daß der Aktor und das Zeitglied durch ein Bimetall gebildet sind, das vom Prüfwiderstand erwärmt wird. Wenn dann das Bimetall ausbiegt, wirkt es auf das Schaltschloß ein und entklinkt dieses, so daß die Kontaktstellen in den Netzleitern bleibend geöffnet werden.

Weitere vorteilhafte Ausgestaltungen der Erfindung sind den weiteren Unteransprüchen zu entnehmen.

Anhand der Zeichnung, in der einige Ausführungsbeispiele der Erfindung dargestellt sind, sollen die Erfindung sowie weitere vorteilhafte Ausgestaltungen und Verbesserungen der Erfindung und weitere Vorteile näher erläutert und beschrieben werden.

Es zeigen:
- Fig. 1: eine schematische Schaltungsanordnung einer Fehlerstromschutzschaltung für einen Fehlertromschutzschalter,
- Fig. 2: eine Ausführungsform der Erfindung mit einem Thermobimetall,
- Fig. 3: eine weitere Ausgestaltung der Erfindung und
- Fig. 4: einen Auslöser, wie er bei der Schaltungsanordnung gemäß Fig. 3 zur Anwendung kommt.

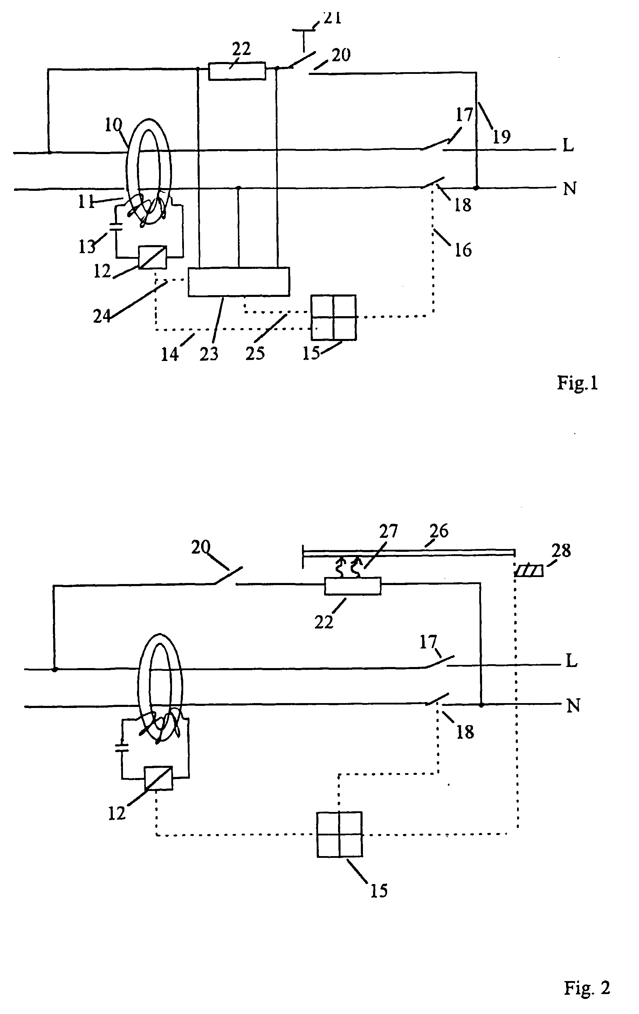

Die Fehlerstromschutzschaltung gemäß Fig. 1 schützt Netzleiter L und N, von denen der Netzleiter L der Phasenleiter und der Netzleiter N der Neutralleiter ist. Die Netzleiter L, N bilden die Primärwicklung für einen Summenstromwandler 10, dessen Sekundärwicklung 11 mit einem Auslöserelais 12 verbunden ist, wobei im Sekundärkreis ein Kondensator 13 zur Anpassung angeordnet ist. Das Auslöserelais 12 wirkt über einen Wirklinie 14 auf ein Schaltschloß 15, welches über eine Wirklinie 16 auf Kontaktstellen 17 und 18 in den Netzleitern L und N einwirkt. Zwischen dem Netzleiter L und dem Neutralleiter N befindet sich ein Prüfstromkreis 19, der einen Prüfkontakt 20 aufweist, der mit einer Prüftaste 21 geschlossen werden kann. Innerhalb des Prüfstromkreises 19 ist ein Prüfwiderstand 22 angeordnet und parallel zu diesem ein Zeitglied 23, dem ein Aktor zugeordnet ist, wie weiter unten näher erläutert werden soll. Wenn durch Drücken der Prüftaste 21 der Prüfkontakt 20 geschlossen wird, dann wird das Zeitglied 23 angesteuert und beginnt zu laufen; sobald der Auslöser 12 angesprochen hat, wird über die Wirklinie 24 das Zeitglied wieder zurückgesetzt. Wenn der Auslöser 12 nicht angesprochen hat, dann wird das Zeitglied 23 nicht angesteuert, d. h. nicht zurückgesetzt und nach einer bestimmten Zeit betätigt der dem Zeitglied zugeordnete Aktor über eine Wirklinie 25 das Schaltschloß 15, so daß die Kontaktstellen 17 und 18 bleibend geöffnet werden.

Gemäß einer ersten Ausführungsform, siehe Fig. 2, ist dem Prüfwiderstand 22 ein Thermobimetall 26 zugeordnet, welches durch die Erwärmung des Prüfstromkreises gemäß den Wärmestrahlen 27 erwärmt und ausgebogen wird. Das Thermobimetall 26 zusammen mit dem Prüfwiderstand 22 ist ein Zeitglied und gleichzeitig auch ein Aktor, der über die Wirklinie 25 (siehe Fig. 1) auf das Schaltschloß 15 einwirkt. Wenn also der Prüfkontakt 20 geschlossen ist, der Auslöser 12 aber nicht anspricht, so daß das Schaltschloß 15 nicht entklinkt wird, dann erwärmt sich das Thermobimetall 26 aufgrund der Erwärmung des Prüfwiderstandes 22 weiter, biegt aus und betätigt das Schaltschloß 15, wodurch die Kontaktstellen 17 und 18 bleibend geöffnet werden. Durch ein im Fehlerstromschutzschalter vorgesehenes Rastelement 28 bleibt das Thermobimetall in der ausgebogenen Stellung und wird dort festgehalten, so daß es auf das Schaltschloß 15 auch nach Ausschalten einwirkt, so daß der Schalter durch einfaches Einschalten der Kontaktstellen 17, 18 nicht mehr eingeschaltet werden kann, sondern erst nach bewußtem Zurücksetzen des Rastelementes 28.

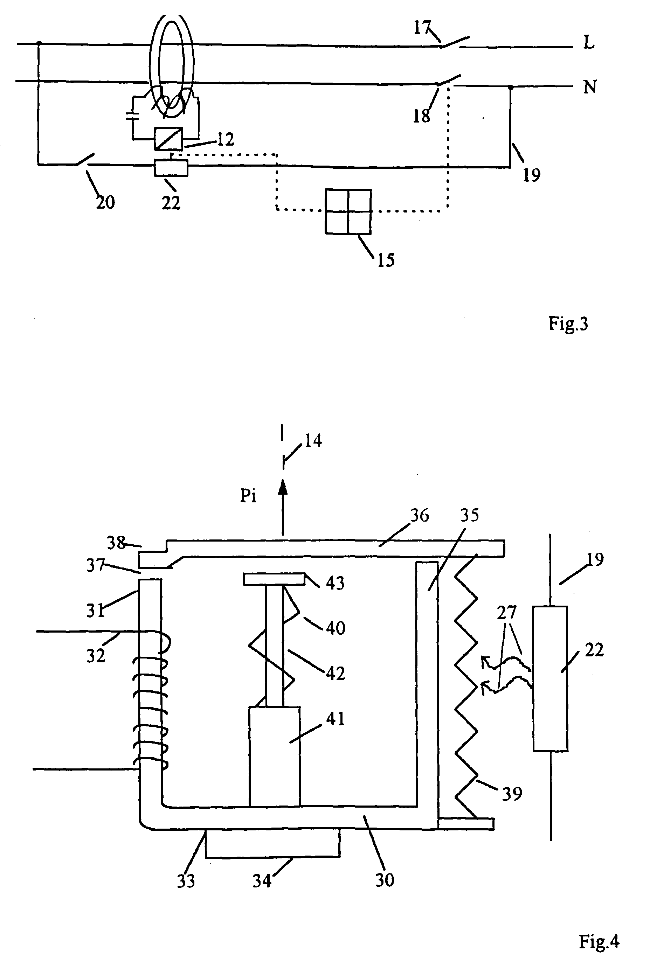

Bei der Ausführung gemäß Fig. 3 ist der Prüfwiderstand 22 dem Auslöserelais 12 zugeordnet, wie in Fig. 4 näher dargestellt.

Das Auslöserelais 12 besitzt ein U-förmiges Magnetjoch 30, an dessen einem Schenkel 31 eine Auslösewicklung 32 angeordnet ist; am Steg 33 des U-förmigen Joches ist ein Permanentmagnet 34 angebracht; am anderen Schenkel 35 ist ein Klappanker 36 aufgelagert, der die Stirnfläche 37 des Schenkels 31 überdeckt. Der Permanentmagnet 34 erzeugt im Joch einen Magnetfluß, aufgrund dessen der Klappanker 36 mit seinem freien Ende 38 an die Stirnfläche 37 angezogen wird. Bei Auftreten eines Fehlerstromes wird im Joch 30 ein Magnetfluß erzeugt, der dem vom Permanentmagneten 34 herrührenden Magnetfluß entgegengesetzt gerichtet ist, so daß die Anziehungskraft auf das freie Ende 38 des Klappankers 36 reduziert und der Klappanker 36 durch die Kraft einer außerhalb des Joches 30 befindlichen Klappankerfeder 39 in Öffnungsstellung gelangt, wodurch gemäß Pfeilrichtung P dann über die Wirklinie 14 das Schaltschloß geöffnet wird. Vereinzelt kann es aufgrund von Haltekräften der Fall auftreten, daß der Klappanker 36 nicht in Öffnungsstellung geht. Im Fall einer Prüfung durch Schließen des Prüfkontaktes 20 erwärmt sich der Prüfwiderstand 22 und gibt seine Wärme über die Wärmeleitung 27 auf die aus einer Formgedächtnislegierung bestehende Auslösefeder 39 ab, so daß sich deren Kristallstruktur ändert und den Klappanker irreversibel in die Ausschaltstellung verdreht.

Es besteht weiterhin die Möglichkeit, wie in der Figur 4 dargestellt, eine zusätzliche, weitere Feder 40 aus einer Formgedächtnislegierung einzusetzen. Zu diesem Zweck besitzt das Joch an seinem Steg 30 eine parallel zu den Schenkeln 31 und 35 vorspringende Führungsstange 41, an der ein Stangenabschnitt 42 mit verringertem Durchmesser anschließt, an dessen freiem Ende ein Absatz 43 angeformt ist. Der Stangenabschnitt 42 ist innerhalb des Abschnittes 41 verschieblich geführt und bei Erwärmung der Feder 40 aus einer Formgedächtnislegierung wird der Stangenabschnitt 42 von der Feder in Pfeilrichtung Pᵢ bewegt, so daß der Klappanker 36 aufgerissen wird. Selbstverständlich wird die Wärme auch zur weiteren Feder 40 bewegt. In diesem Fall wäre die Feder 39 diejenige Feder, die den Klappanker im Normalfall öffnet; sie wäre nicht aus einer Formgedächtnislegierung hergestellt.

Der Prüfwiderstand wird demgemäß bei längerer Betätigung der Prüftaste bzw. bei längerem Schließen des Prüfkontaktes 20 warm; seine Maximaltemperatur und der zeitliche Verlauf der Aufheizung ist abhängig von der Baugröße des Widerstandes 22.

Bei kombinierten Geräten FI/LS (Fehlerstromschutzschalter/Leitungsschutzschalter) kann das Bimetall 26 durch das Bimetall des Leitungsschutzschalterpoles gebildet sein.

## Patentansprüche

1. Einrichtung zum Prüfen eines Fehlerstromschutzschalters, mit einem Summenstromwandler (10), dessen Primärwicklung durch Netzleiter (L, N) gebildet und dessen Sekundärwicklung (11) mit einem Auslöserelais (12) verbunden sind, mit einem Schaltschloß (15), das vom Auslöserelais (12) bei Auftreten eines Fehlerstromes entklinkt wird, so daß Hauptkontaktstellen (17, 18) in den Netzleitern (L, N) bleibend geöffnet werden, und mit einem Prüfstromkreis (19), mit dem zwischen einem Phasenleiter (L) und dem N-Leiter ein Fehlerstrom simuliert wird und der einen Prüfkontakt (20) und einen Prüfwiderstand (22) enthält, dadurch gekennzeichnet, daß der Prüfstromkreis (19) ein Zeitglied (23) aufweist, mit dem eine vorbestimmte Zeitdauer nach Schließen des Prüfkontaktes (20) ein Aktor (26, 39,40) ansteuerbar ist, der das bleibende, ggf. irreversible Ausschalten des Fehlerstromschutzschalters bewirkt.

2. Einrichtung nach Anspruch 1, dadurch gekennzeichnet, daß der Aktor das Auslöserelais (12) betätigt.

3. Einrichtung nach Anspruch 2, dadurch gekennzeichnet, daß der Aktor die Feder (39) des Auslöserelais (12) ist, die vom Prüfwiderstand (22) erwärmt wird und ihre Federkonstante verändert, so daß der Anker (36) des Auslöserelais (12) geöffnet wird.

4. Einrichtung nach Anspruch 3, dadurch gekennzeichnet, daß die Feder (39) aus einer Formgedächtnislegierung besteht.

5. Einrichtung nach Anspruch 2, dadurch gekennzeichnet, daß eine weitere Feder (40) vorgesehen ist, die aus einer Formgedächtnislegierung besteht und direkt auf den Anker (36) einwirkt.

6. Einrichtung nach Anspruch 5, mit einem U-förmigen Auslöserelais, das als Permanentmagnetauslöser wirkt, dadurch gekennzeichnet, daß die weitere Feder parallel zu den beiden Schenkeln (31, 35) zwischen diesen und zwischen dem Steg (30) und dem Anker (36) angeordnet ist.

7. Einrichtung nach Anspruch 1, dadurch gekennzeichnet, daß der Aktor das Schaltschloß (15) des Fehlerstromschutzschalters entklinkt.

8. Einrichtung nach Anspruch 5, dadurch gekennzeichnet, daß der Aktor und das Zeitglied durch ein Thermobimetall (26) gebildet sind, das vom Prüfwiderstand (22) erwärmt wird und das Schaltschloß ggf. irreversibel entklinkt.
